# FASCICULE DE BREVET EUROPEEN

(11) **EP 1 344 744 B1**
(45) Date de publication et mention de la délivrance du brevet: **06.06.2012**
(21) Numéro de dépôt: 03354019.6
(22) Date de dépôt: 27.02.2003
(51) Int. Cl.: B81B 1/00, F15C 5/00, B01J 19/00

(54) **Microvanne à actionnement pyrotechnique**
Pyrotechisch getriebenes Mikroventil
Microvalve with pyrotechnic actuating

(30) Priorité: 11.03.2002 FR 0203016
(43) Date de publication de la demande: 17.09.2003
(73) Titulaire: Commissariat à l'Énergie Atomique et aux Énergies Alternatives, 75015 Paris (FR)
(72) Inventeur: Delapierre, Gilles, 38180 Seyssins (FR)
(74) Mandataire: Hecké, Gérard

(56) Documents cités:
- WO-A-98/22719
- FR-A1- 2 561 743
- US-A- 3 358 961
- US-A- 3 483 695
- US-A- 4 111 221
- US-B1- 6 284 195
- DUFOUR M ET AL: "A COMPARISON BETWEEN MICROMACHINED PRESSURE SENSORS USING QUARTZ OR SILICON VIBRATING BEAMS" SENSORS AND ACTUATORS A, ELSEVIER SEQUOIA S.A., LAUSANNE, CH, vol. A34, no. 3, 1 septembre 1992 (1992-09-01), pages 201-209, XP000319953 ISSN: 0924-4247

## Description

### Domaine technique de l'invention

L'invention concerne une microvanne destinée à permettre ou à empêcher la mise en communication d'extrémités de microcanaux d'un composant microfluidique, sous le contrôle d'une charge de matériau pyrotechnique.

### État de la technique

Les analyses biologiques font appel à une succession de réactions biologiques élémentaires. Leur mise en oeuvre nécessite actuellement plusieurs postes de travail correspondant à différentes étapes élémentaires d'un protocole d'analyse. Ceci implique beaucoup de manipulations et, en conséquence, un facteur d'erreur non négligeable, une durée d'analyse élevée, une consommation importante de réactifs et d'échantillons, donc un coût élevé par analyse.

Pour diminuer les coûts et simplifier la mise en oeuvre de telles analyses, il a été proposé d'intégrer l'ensemble des étapes du protocole d'analyse dans un microsystème unique. Les microtechnologies permettent de réaliser des micropompes, des microvalves, des micromoteurs, des microfiltres et des mélangeurs pouvant être intégrés dans un dispositif microfluidique comportant des chambres réactionnelles et/ou des microréservoirs interconnectés par un réseau de microcanaux.

Des microvannes peuvent être utilisés dans un composant microfluidique comportant des microcanaux et/ou des microréservoirs et/ou des microréacteurs pour permettre ou empêcher la communication entre les différents microcanaux, microréservoirs ou microréacteurs.

Le brevet US 6.168.948 décrit un microsystème d'analyse génétique, microlaboratoire ou biopuce, intégrant l'ensemble des étapes d'analyse d'acides nucléiques sur une surface de la taille d'une carte de crédit. Pour gérer la circulation de fluides dans les microcanaux, ce microlaboratoire utilise comme micro-actuateurs essentiellement des microvalves destinées à ouvrir un canal lors d'une étape prédéterminée de l'analyse. Les micro-actuateurs peuvent également maintenir une chambre sous vide et, sous l'effet d'une commande d'ouverture, provoquer son remplissage par un fluide. Les microvalves, comportant une membrane déformable, peuvent être actionnées par application d'un vide ou d'une pression externe, électromagnétiquement, électrostatiquement ou par couplage avec un micro-actuateur piézoélectrique.

Les différents types d'actionnement de microvalves connus présentent tous des inconvénients majeurs pour les applications utilisant des composants microfluidiques constituant des microlaboratoires ou biopuces. En effet, ces composants, à usage unique, sont destinés à être utilisés chez un patient, chez un médecin, sur un lieu d'accident, etc... Ils doivent donc être le plus compact possible avec un système externe de commande réduit au strict minimum.

Par ailleurs, le document WO-A-9822719 et le brevet US 6247485 correspondant décrivent un appareil d'administration transdermique de médicament utilisant trois micro-actionneurs pyrotechniques. Deux de ces micro-actionneurs sont destinés à casser une zone amincie d'une membrane solide, pour former des orifices de passage d'un fluide, tandis que le troisième micro-actionneur est utilisé pour gonfler une enveloppe destinée à chasser le fluide à travers les orifices de passage formés par les deux autres micro-actionneurs. Ce dispositif est complexe et le contact du fluide avec le matériau pyrotechnique n'est pas compatible avec son utilisation dans un microlaboratoire d'analyse dans lequel toute pollution d'un échantillon à analyser doit être évitée. On peut également utiliser une membrane déformée par la pression pour obturer un microcanal formé dans un substrat et dans lequel circule un fluide.

Ces différents types de micro-actionneurs présentent l'inconvénient de ne pas permettre de réaliser aussi bien des vannes de fermeture que des vannes d'ouverture des microcanaux. Or, ces deux fonctions sont généralement indispensables dans un même dispositif d'analyse. Il est évidemment envisageable d'utiliser deux types différents de micro-actionneurs sur une même carte pour réaliser, d'une part, des microvannes à fermeture et, d'autre part, des microvannes à ouverture. Une telle solution est cependant très compliquée et, en conséquence, très coûteuse, sans compter les problèmes de compatibilité que cela provoquerait au cours des diverses étapes de fabrication.

Le brevet US 3358961 décrit une vanne utilisant des moyens pyrotechniques pour déplacer un piston prolongé d'un obturateur ayant une lumière.

Le brevet FR 2561743 décrit une vanne pyrotechnique dans laquelle un ou plusieurs dispositifs pyrotechniques déforment une membrane équipée d'une masselotte rigide qui projette un poinçon.

### Objet de l'invention

L'invention a pour but d'écarter les inconvénients des microvannes connues et, plus particulièrement, de permettre de réaliser, avec une même technique, des microvannes destinées à être ouvertes et des microvannes destinées à être fermées. Les microvannes doivent comporter des moyens d'actionnement fiables, de faible consommation, bon marché, de conception simple et robuste, opérationnels uniquement lors d'une analyse et tolérant un stockage de plusieurs années.

Selon l'invention, ce but est atteint par une vanne selon les revendications annexées et, plus particulièrement, par le fait que ladite vanne étant une microvanne, le piston est un mini-piston comportant une partie déformable sous l'action desdits gaz, ladite partie déformable étant solidaire d'une partie mobile du mini-piston comportant la lumière, la cavité étant délimitée par au moins un substrat, et la partie déformable du mini-piston et en ce que les extrémités à mettre en communication débouchant sur une face d'un premier substrat planaire, dans lequel sont réalisés les microcanaux du composant microfluidique, le mini-piston est formé dans un second substrat planaire, destiné être accolé au premier substrat planaire, et comporte une partie mobile dans le plan du second substrat, la lumière étant formée dans la partie mobile du mini-piston, la partie déformable du mini-piston comportant des zones de liaison entre le substrat et la partie mobile du mini-piston.

La partie mobile du mini-piston peut alors être mobile en translation ou en rotation dans le plan du second substrat.

Le mini-piston peut également comporter une partie déformable solidaire de la partie mobile, la déformation de la partie déformable, perpendiculairement au plan du second substrat, en réponse à la mise à feu de la charge pyrotechnique provoquant le déplacement de la partie mobile.

### Description sommaire des dessins

D'autres avantages et caractéristiques ressortiront plus clairement de la description qui va suivre de modes particuliers de réalisation de l'invention donnés à titre d'exemples non limitatifs, et représentés aux dessins annexés, dans lesquels :
Les figures 1 et 2 représentent schématiquement, en coupe, une microvanne selon l'art antérieur, respectivement avant et après actionnement.
Les figures 3 et 4 représentent schématiquement un dispositif de remplissage d'un réservoir dans un appareil d'administration transdermique de médicament selon l'art antérieur, respectivement avant et après actionnement.
La figure 5 illustre, en coupe, un composant microfluidique comportant un premier exemple de deux microvannes premier, l'une normalement ouverte et l'autre normalement fermée.
La figure 6 illustre un étage actionneur pouvant être utilisé avec des microvannes selon figure 5.
Les figures 7 et 8 illustrent un mode particulier de réalisation de mini-pistons de microvannes selon la figure 5.
La figure 9 représente une vue, en coupe selon A-A, d'un mode de réalisation d'une microvanne selon l'invention.
La figure 10 représente la microvanne de la figure 9, en coupe selon B-B.
Les figures 11 à 13 illustrent des variantes de réalisation d'une microvanne selon les figures 9 et 10.
La figure 14 représente une vue, en coupe selon C-C, d'un deuxième mode de réalisation d'une microvanne selon l'invention.
La figure 15 représente la microvanne de la figure 14, en coupe selon D-D.

### Description de modes particuliers de réalisation.

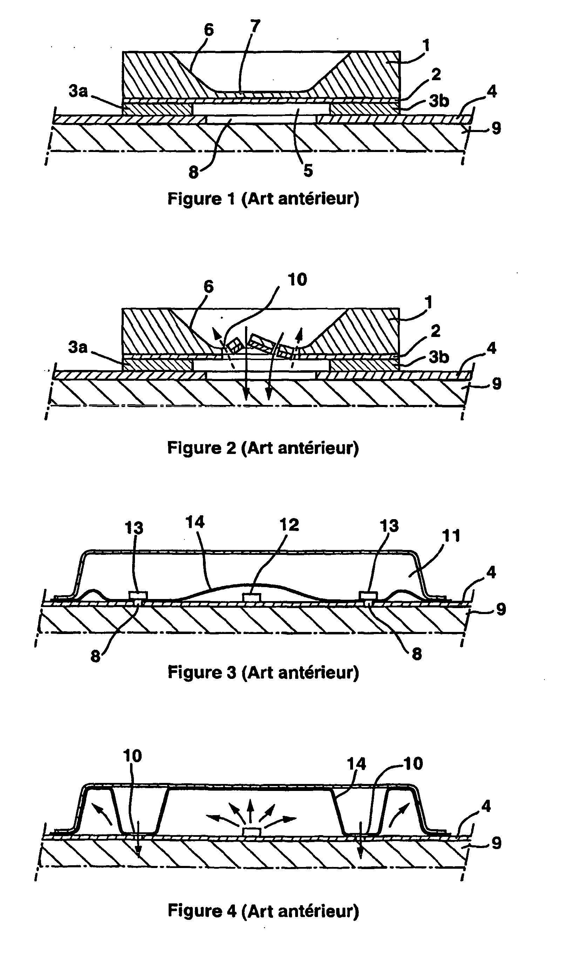

La microvanne selon les figures 1 et 2 est destinée à être utilisée dans un appareil d'administration transdermique de médicament (WO-A-9822719 et brevet US 6247485 correspondant). Elle comporte un substrat 1, en matériau semi-conducteur, par exemple en silicium, portant une résistance électrique 2 dont les extrémités sont connectées à des contacts métalliques 3a et 3b soudés à des pistes conductrices d'un circuit imprimé 4. Une charge 5 de matériau combustible est disposée, sous forme de couche mince, sur la résistance électrique 2, entre les contacts 3a et 3b. Le matériau de la charge 5 est un matériau pyrotechnique, par exemple de type nitrocellulose. Le substrat 1 comporte une cratère pyramidal tronqué 6 de manière à former à sa partie inférieure une zone amincie 7 accolée à la résistance 2 au-dessus de la charge 5. Le circuit imprimé 4 est percé d'un trou 8 face à la zone amincie 7 du substrat 1. Le trou 8 est fermé par une couche 9, par exemple d'hydrogel, destinée à être chargée avec un principe actif contenu dans une poche (non représentée) communiquant avec le cratère 6.

Le passage du courant dans la résistance électrique 2 provoque, par effet Joule, un dégagement de chaleur qui assure l'inflammation de la charge pyrotechnique 5. Celle-ci dégage alors une quantité de gaz suffisante pour que la pression provoque la rupture de la zone amincie 7 du substrat 1 et de la partie accolée de la résistance 2, formant des passages 10 (figure 2) pour l'échappement des gaz (flèches en pointillé) et pour le passage d'un liquide (flèches en trait plein) de la poche communiquant avec le cratère 6, à travers le trou 8, vers la couche d'hydrogel 9, qui constitue, par exemple, un réservoir d'appareil d'administration transdermique de médicament.

Un appareil connu d'administration transdermique de médicament utilisant trois microvannes munies de microactionneurs pyrotechniques est représenté aux figures 3 et 4. Une poche 11 contient une solution ionique, destinée à venir hydrater la couche d'hydrogel 9 lorsque les trois microvannes sont actionnées par l'intermédiaire d'une feuille de circuit imprimé 4 disposée entre la couche 9 et la poche 11. Une première microvanne 12 est fixée sur la feuille de circuit imprimé 4, en position centrale, et plusieurs microvannes 13 sont disposées autour de la microvanne 12. Une enveloppe gonflable 14, enfermant la microvanne centrale 12, est pincée contre la feuille de circuit imprimé par les microvannes 13 et par la poche 11.

Les microvannes 13 sont du type représenté aux figures 1 et 2, tandis que la microvanne 12 s'en distingue par le fait qu'elle ne comporte pas de trou 8. La mise à feu des charges combustibles des microvannes 13 ouvre des passages 10 (figure 4) entre la poche 11 et le réservoir constitué par la couche d'hydrogel 9. La mise à feu de la charge combustible de la microvanne centrale 12 provoque la rupture de la zone amincie 7 correspondante et les gaz dégagés provoquent le gonflement de l'enveloppe gonflable 14. Celle-ci vient alors occuper une grande partie du volume intérieur de la poche 11, chassant la solution ionique contenue dans la poche 11 à travers les microvannes 13 et les passages 10 associés préalablement formés par l'actionnement des microvannes 13.

Ce dispositif est complexe et le contact du fluide contenu dans la poche 11 avec le matériau pyrotechnique, les gaz de combustion du matériau pyrotechnique et les débris de la zone amincie 7 du substrat 1 n'est pas compatible avec son utilisation dans un microlaboratoire d'analyse dans lequel toute pollution d'un échantillon à analyser doit être évitée.

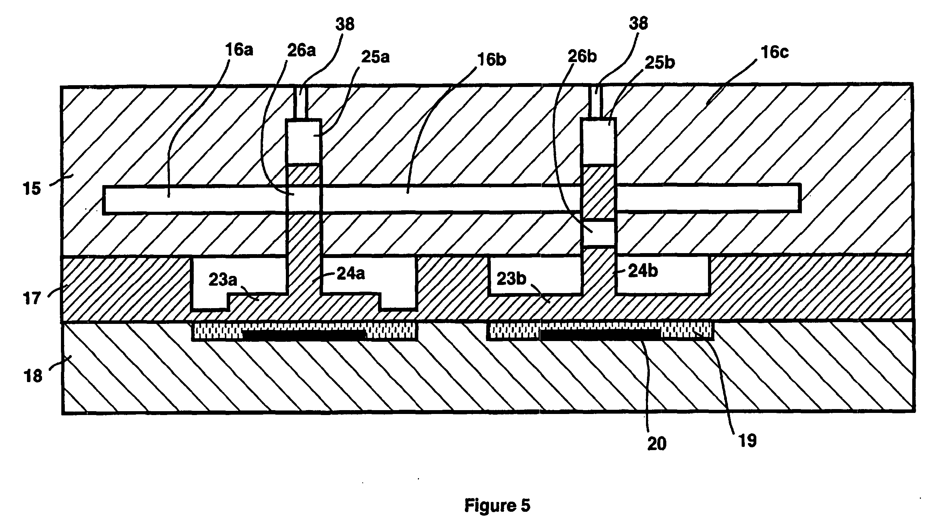

Le composant microfluidique de la figure 5 comporte un premier exemple de deux microvannes, l'une normalement ouverte et l'autre normalement fermée. Le composant microfluidique est constitué par la superposition de trois cartes, constituées chacune par au moins un substrat planaire et qui peuvent être solidarisées par tout moyen approprié, par exemple par collage. Une première carte 15 comporte les microcanaux 16 et/ou les microréservoirs et/ou les microréacteurs constituant le réseau microfluidique du composant. Elle comporte au moins un premier substrat planaire, de préférence en matière plastique, par exemple en polymère, les microcanaux pouvant être gravés en surface ou sur un substrat additionnel, en matière plastique, en verre, en silicium ou en quartz, rapporté sur le substrat en plastique.

Une seconde carte 17 constitue la carte vanne. Sur la figure 5, elle est constituée par un substrat dans lequel sont formées deux microvannes.

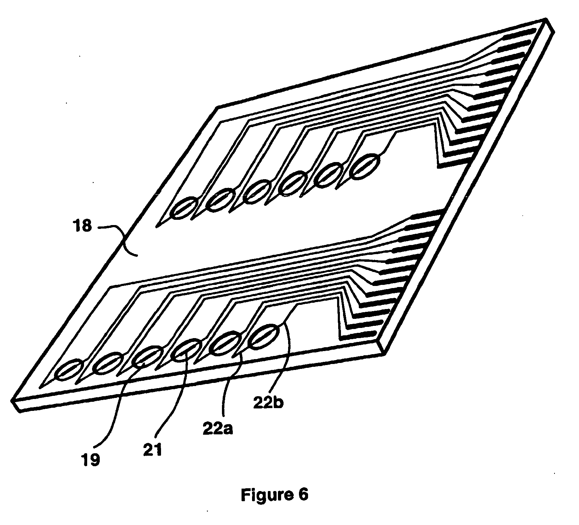

Une troisième carte 18 constitue l'étage actionneur et comporte un substrat planaire en silicium, en matière plastique ou en verre, dans lequel sont formées des cavités 19. Une charge pyrotechnique 20 est disposée dans chacune des cavités 19. La mise à feu d'une charge pyrotechnique est réalisée par tout moyen approprié, par exemple (figure 6) au moyen d'une résistance 21, disposée dans chaque cavité 20 et alimentée par deux pistes conductrices associées 22a et 22b. Une charge pyrotechnique 20 est déposée sur chaque résistance 21, par exemple par sérigraphie ou par dépôt localisé à l'aide de micropipettes piézoélectriques. Chaque charge pyrotechnique 20 peut être mise à feu indépendamment, par l'intermédiaire des pistes conductrices associées. Le circuit de contrôle de la mise à feu des charges pyrotechniques est, de préférence, formé sur la carte 18.

Comme illustré à la figure 5, chaque charge pyrotechnique 20 est disposée en regard d'une microvanne de la seconde carte 17. La mise à feu d'une charge pyrotechnique provoque le dégagement de gaz et, en conséquence, l'actionnement de la microvanne associée.

Une microvanne représentée à la figure 5 comporte un mini-piston qui se déplace perpendiculairement au plan de la carte vanne, vers le haut sur la figure 5, sous la poussée des gaz dégagés par la mise à feu de la charge pyrotechnique 20 associée. Chaque mini-piston comporte une base 23 (23a, 23b) et une tige 24 (24a, 24b). La base 23 est constituée par une zone de plus faible épaisseur de la carte 17, située en regard d'une cavité 19 contenant une charge pyrotechnique 20. La base d'un mini-piston peut avoir une épaisseur constante (base 23b) ou comporter une zone de plus faible épaisseur sur sa périphérie (base 23a) facilitant la déformation de la base sous la poussée des gaz générés par la mise à feu de la charge pyrotechnique 20. La tige 24 d'un mini-piston est sensiblement perpendiculaire à la base 23 et son extrémité libre se déplace par coulissement à l'intérieur d'une fente transversale 25 (25a, 25b) associée, formée dans la carte 15. Les tiges 24 sont, de préférence, emmanchées légèrement à force dans les fentes 25 correspondantes, ce qui permet d'assurer l'étanchéité des mini-pistons. Un évent 38 est, de préférence, situé à l'extrémité de chaque fente 25.

Chaque tige 24 comporte une lumière, constituée par un orifice transversal 26 (26a, 26b). Selon la position de l'orifice transversal de la tige vis-à-vis des extrémités des microcanaux à mettre en communication, la microvanne correspondante est normalement ouverte ou fermée. Ainsi, sur la figure 5, une première microvanne (23a, 24a, 26a) est normalement ouverte, son orifice transversal 26a étant situé, dans la fente 25a correspondante, au niveau des extrémités opposées des microcanaux 16a et 16b à mettre en communication.

Par contre, la seconde microvanne (23b, 24b, 26b) est normalement fermée, son orifice transversal 26b étant situé, dans la fente 25b correspondante, au-dessous du niveau des extrémités opposées des microcanaux 16b et 16c à mettre en communication.

La mise à feu d'une charge pyrotechnique 20 provoque un dégagement de gaz exerçant une poussée sur le mini-piston associé. La base 23 du mini-piston se déforme alors et pousse la tige 24 correspondante, vers le haut sur la figure 5, dans la fente 25 correspondante. La pression fournie par les gaz dégagés par la mise à feu de la charge pyrotechnique est suffisante pour vaincre le frottement dû à l'emmanchement forcé de la tige 24 dans la fente 25. La première microvanne (23a, 24a, 26a) se ferme après mise à feu de la charge 20 correspondante, l'orifice transversal 26a de sa tige 24a s'étant alors déplacé vers le haut et se trouvant au-dessus du niveau des extrémités opposées des microcanaux 16a et 16b initialement en communication. Par contre, La seconde microvanne (23b, 24b, 26b) s'ouvre après mise à feu de la charge 20 correspondante, l'orifice transversal 26b de sa tige 24b s'étant alors déplacé vers le haut et se trouvant au niveau des extrémités opposées des microcanaux 16b et 16c à mettre en communication.

Les cavités 19 sont, de préférence remplies d'un matériau, par exemple de résine, pour permettre d'exercer un appui sur la carte 18 lors de l'insertion des tiges 24 dans les fentes 25.

À titre d'exemple, le diamètre d'un orifice 26, correspondant sensiblement au diamètre des microcanaux 16, est de l'ordre de quelques dizaines à quelques centaines de micromètres et la largeur de la base 23 d'un mini-piston, correspondant sensiblement à la largeur d'une cavité 19, est de l'ordre du millimètre.

Ainsi, la carte vanne 17 comporte des microvannes destinées à être ouvertes et des microvannes destinées à être fermées qui peuvent être réalisées avec une même technique. La personnalisation d'une microvanne (à ouvrir ou à fermer) se fait très facilement au cours de la fabrication, uniquement par le positionnement approprié de l'orifice transversal 26 correspondant.

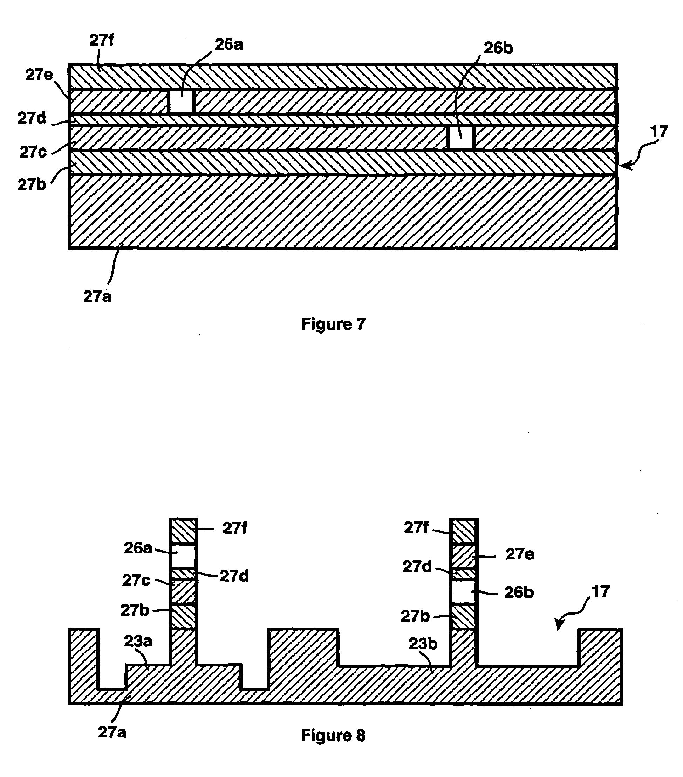

Les divers éléments constitutifs de la carte vanne 17 peuvent être réalisés par usinage et/ou par moulage du substrat. Les figures 7 et 8 illustrent un mode de réalisation préférentiel de la carte vanne 17. Dans une première étape, on réalise un empilement de couches planes 27. Sur la figure 7, l'empilement comporte six couches 27a à 27f, en matière plastique ou en silicium. L'empilement de couches est ensuite usiné de la manière représentée à la figure 8 pour former la carte vanne 17 de la figure 5. Ainsi, les bases 23a et 23b des mini-pistons sont formées dans la première couche 27a, la plus épaisse. Les couches 27b et 27d constituent des couches intercalaires de différentes épaisseurs, permettant de situer précisément, en hauteur, les couches 27e et 27c dans lesquelles sont respectivement formés des orifices traversants, dont la largeur est supérieure ou égale à la largeur de la tige d'un mini-piston et constituant respectivement, après usinage de l'empilement, les orifices 26a et 26b des tiges 24a et 24b des mini-pistons. La couche supérieure 27f de l'empilement constitue les extrémités libres des tiges.

Un tel mode de réalisation est particulièrement simple. En effet, seules des couches planes sont moulées et leur empilement permet de définir précisément la position des orifices des tiges des mini-pistons. Dans un mode de réalisation préférentiel, les tiges 24 ont une section rectangulaire en vue de dessus.

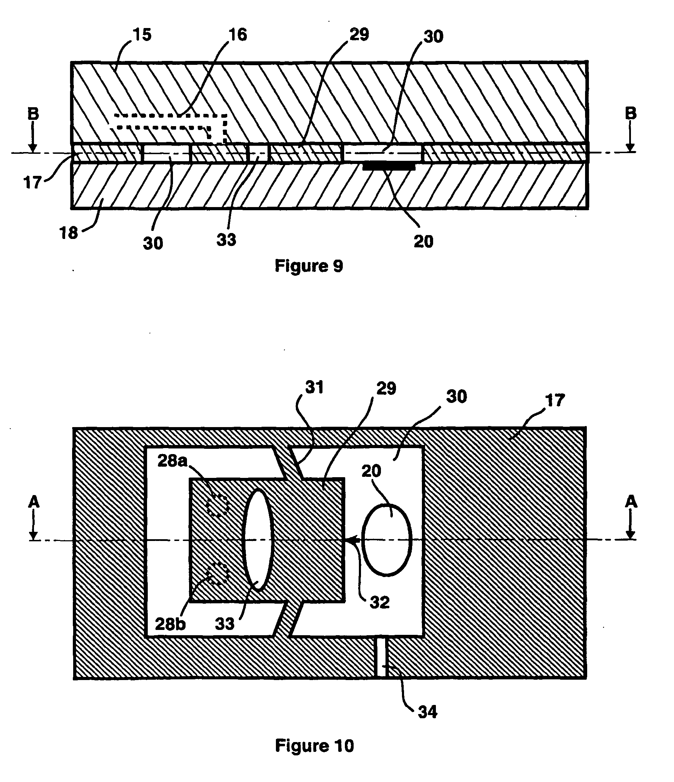

Un second mode de réalisation d'une microvanne selon l'invention est illustré aux figures 9 et 10. Comme précédemment, le composant microfluidique comporte une première carte 15, comportant les microcanaux 16 et/ou les microréservoirs et/ou les microréacteurs constituant le réseau microfluidique du composant, une carte vanne 17 et une troisième carte 18, constituant l'étage actionneur. Dans ce mode de réalisation, les extrémités 28 des microcanaux 16 à mettre en communication débouchent sur la face inférieure (figure 9) du substrat planaire constituant la première carte 15.

La carte vanne 17 comporte un mini-piston 29 pouvant se déplacer dans un évidement 30 de la carte vanne 17, dans le plan de la carte vanne, c'est-à-dire perpendiculairement aux extrémités 28 des microcanaux. Sur la figure 10, le mini-piston 29 est rattaché à la périphérie de l'évidement 30 par de minces zones de liaison 31. Une charge pyrotechnique 20 est disposée, dans la carte 18 constituant l'étage actionneur, en regard d'une extrémité de l'évidement 30, sur la droite du mini-piston 29 sur les figures 9 et 10. La mise à feu de la charge pyrotechnique provoque le dégagement de gaz, dont la pression s'exerce sur le mini-piston et provoque le déplacement de celui-ci vers la gauche des figures 9 et 10, dans le sens indiqué par la flèche 32, les zones de liaison 31 se déformant pour permettre ce déplacement. Le mini-piston comporte une lumière 33.

Sur les figures 9 et 10, la microvanne représentée est normalement fermée. Le mini-piston 29 empêche normalement toute communication entre les extrémités 28a et 28b des microcanaux à mettre en communication. Les emplacements des extrémités 28a et 28b sont représentés en pointillés sur la figure 10. lls sont disposés perpendiculairement à l'axe de déplacement du mini-piston 29. Lorsque celui-ci s'est déplacé, vers la gauche, après mise à feu de la charge pyrotechnique, la lumière 33, de forme oblongue et sensiblement perpendiculaire au sens de déplacement du piston 29, est alors disposée en regard des deux extrémités 28a et 28b et assure leur mise en communication. Un évent calibré 34 est, de préférence, prévu dans la carte 17 pour permettre l'évacuation des gaz après actionnement de la microvanne. L'évent 34 est calibré de manière à ce que la surpression générée très rapidement après la mise à feu de la charge pyrotechnique 20 soit suffisante pour déplacer le mini-piston 29 mais baisse ensuite rapidement. Les gaz dégagés n'ont ainsi pas le temps d'atteindre les canaux contenant les réactifs. L'étanchéité entre la carte actionneur 18 et la carte 15 contenant les microcanaux n'a donc pas à être aussi poussée qu'en l'absence d'évent.

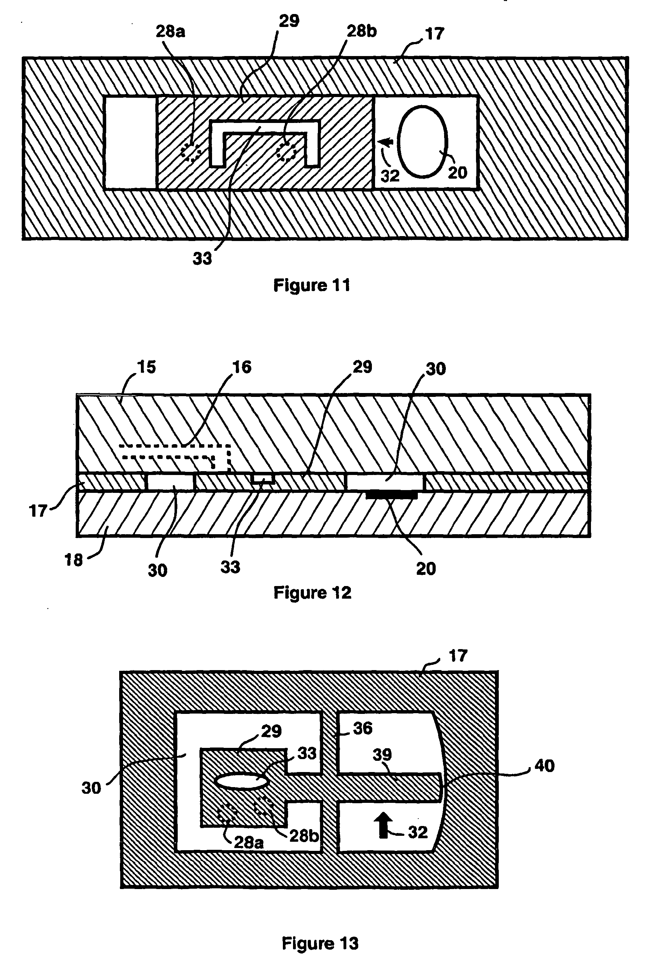

Diverses formes de mini-pistons et de lumières peuvent être envisagées. Dans la variante représentée à la figure 11, les zones de liaison 31 sont supprimées et le piston 29 est emmanché légèrement à force dans l'évidement 30. Les emplacements des extrémités 28a et 28b peuvent être sensiblement parallèles au sens de déplacement du mini-piston (flèche 32). Dans ce cas, la lumière 33 est sensiblement parallèle au sens de déplacement du piston. Dans le mode de réalisation particulier représenté sur la figure 11, la lumière 33 a sensiblement la forme d'un U, dont la base est parallèle à l'axe passant par les extrémités 28a et 28b et dont les extrémités des branches sont destinées à venir en regard des extrémités 28a et 28b des microcanaux après actionnement de la microvanne.

La lumière 33 représentée à la figure 9 traverse le mini-piston 29 perpendiculairement au plan de la carte vanne 17. Dans la variante de réalisation illustrée à la figure 12, la lumière 33 est une lumière borgne, non traversante.

Dans une autre variante, représentée à la figure 13, le déplacement du mini-piston 29 n'est pas linéaire, comme dans les modes de réalisation précédemment décrits, mais rotatif. La forme et la disposition de la lumière 33, disposée à une première extrémité du mini-piston, sont adaptées en conséquence. Sur la figure 13, le mini-piston est rattaché à la périphérie de l'évidement 30 par une barre de liaison 36, transversale, solidaire de la partie centrale du mini-piston. Le mini-piston est mobile en rotation autour d'un centre de rotation situé à l'intersection du mini-piston et de la barre de liaison 36. La charge pyrotechnique 20 est alors disposée de manière à ce que le dégagement de gaz exerce une pression (flèche 32) sur une seconde extrémité du mini-piston, provoquant la déformation de la barre de liaison 36 et la rotation du mini-piston. La seconde extrémité du mini-piston est située à une distance calibrée de la paroi opposée de l'évidement 30, délimitant ainsi un passage 40 jouant le même rôle que l'évent 34 dans la microvanne selon la figure 10.

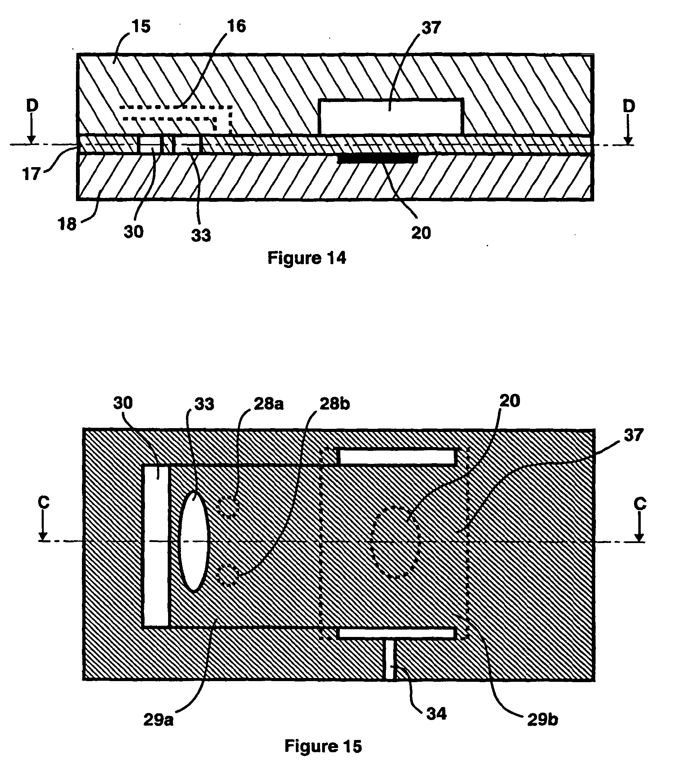

Un deuxième mode de réalisation d'une microvanne selon l'invention est illustré aux figures 14 et 15. Comme dans le premier mode de réalisation (figures 9 à 12), le mini-piston 29 comporte, à son extrémité libre, une partie mobile 29a, dans laquelle est formée la lumière 33 et qui se déplace parallèlement au plan de la carte 17. Le mini-piston comporte en outre une partie déformable 29b, solidaire de la partie mobile 29a. La déformation de la partie déformable s'effectue perpendiculairement au plan de la carte 17, dans une zone située en regard de la charge pyrotechnique 20. Pour permettre cette déformation, la carte 15, contenant les microcanaux 16, comporte une cavité 37, située en regard de la charge pyrotechnique 20 et dont l'emplacement est représenté en pointillés sur la figure 15. La mise à feu de la charge pyrotechnique provoque un dégagement de gaz, qui exerce une pression sur la partie déformable 29b, perpendiculairement au plan de la carte 17. Cette déformation de la partie déformable du mini-piston provoque un retrait de la partie mobile 29a dans l'évidement 30. La partie mobile se déplace donc sur la droite sur la figure 15, amenant ainsi la lumière 33 en regard des extrémités 28a et 28b des microcanaux à mettre en communication. L'emplacement de la lumière 33 dans la partie mobile 29a du mini-piston est adaptée en conséquence.

Les microvannes illustrées sur les figures 9 à 15 sont des microvannes normalement fermées, qui s'ouvrent lors de la mise à feu de la charge pyrotechnique 20 associée. Pour réaliser une microvanne normalement ouverte, qui se ferme lors de la mise à feu de la charge pyrotechnique 20 associée, il suffit de modifier la position relative de la lumière 33 et des emplacements correspondants aux extrémités 28a et 28b, de manière à ce que la lumière 33 mette les extrémités 28a et 28b en communication avant actionnement de la microvanne.

Tandis que le premier exemple (figures 5, 7 et 8) nécessite, pour constituer la carte vanne, la réalisation de pièces de forme tridimensionnelle, assez complexes, avec des orifices transversaux et un emmanchement à force qui peut être délicat à mettre en oeuvre avec un bon rendement de fabrication, les premier et deuxième modes de réalisation (figures 9 à 15) permettent d'utiliser uniquement des techniques planaires, permettant une fabrication plus simple et, en conséquence, moins coûteuse. L'invention présente l'avantage de maintenir la microvanne en position ouverte ou fermée après actionnement sans qu'il soit nécessaire de conserver la force d'actionnement, c'est-à-dire la pression dégagée par la charge pyrotechnique.

## Revendications

1. Vanne destinée à permettre ou à empêcher la mise en communication d'extrémités de canaux d'un système fluidique, par le déplacement d'un piston muni d'une lumière (33) sous la poussée de gaz dégagés par la mise à feu d'une charge (20) pyrotechnique disposée dans une cavité, ladite vanne étant une microvanne, le piston étant un mini-piston comportant une partie déformable sous l'action desdits gaz, ladite partie déformable étant solidaire d'une partie mobile du mini-piston comportant la lumière (33) destinée à réaliser ladite mise en communication, la cavité étant délimitée par au moins un substrat (15, 17, 18), et la partie déformable du mini-piston et les extrémités (28a, 28b) à mettre en communication débouchant sur une face d'un premier substrat planaire (15), dans lequel sont réalisés les microcanaux (16) du composant microfluidique, le mini-piston (29) est formé dans un second substrat planaire (17), destiné être accolé au premier substrat planaire (15), et comporte une partie mobile dans le plan du second substrat, la lumière (33) étant formée dans la partie mobile du mini-piston (29), la partie déformable du mini-piston comportant des zones de liaison (31) entre le substrat et la partie mobile du mini-piston.

2. Vanne selon la revendication 1, **caractérisée en ce que** la microvanne étant normalement ouverte, la lumière (33) du mini-piston met normalement en communication lesdites extrémités (28a, 28b), le mini-piston (29) empêchant ladite communication après mise à feu de la charge pyrotechnique (20).

3. Vanne selon l'une des revendications 1 et 2, **caractérisée en ce que** la microvanne étant normalement fermée, le mini-piston (29) empêche normalement la communication entre les extrémités (28a, 28b), la lumière (33) du mini-piston les mettant en communication après mise à feu de la charge pyrotechnique (20).

4. Vanne selon l'une quelconque des revendications 1 à 3, **caractérisée en ce que** la partie mobile du mini-piston (29) est mobile en translation dans le plan du second substrat (17), la partie déformable du mini-piston comportant une barre de liaison (36) transversale solidaire du mini-piston.

5. Vanne selon l'une quelconque des revendications 1 à 3, **caractérisée en ce que** la partie mobile du mini-piston (29) est mobile en rotation dans le plan du second substrat (17).

6. Vanne selon l'une quelconque des revendications 1 à 3, **caractérisée en ce que** le mini-piston (29) comporte une partie déformable (29b) solidaire de la partie mobile (29a), la déformation de la partie déformable, perpendiculairement au plan du second substrat (17), en réponse à la mise à feu de la charge pyrotechnique (20) provoquant le déplacement de la partie mobile (29a).

7. Vanne selon l'une quelconque des revendications 1 à 6, **caractérisée en ce que** la lumière (33) est une lumière traversante.

8. Vanne selon l'une quelconque des revendications 1 à 6, **caractérisée en ce que** la lumière (33) est une lumière borgne.

9. Vanne selon l'une quelconque des revendications 1 à 8, **caractérisée en ce que** la lumière (33) a sensiblement la forme d'un U.

## Claims

1. A valve designed for enabling or preventing communication of ends of channels of a fluidic system by means of a piston having an aperture (33) moving due to the thrust of gases given off by firing of a pyrotechnic charge (20) disposed in a cavity, said valve being a microvalve, the piston being a minipiston comprising a deformable part deforming due to the thrust of said gases, said deformable part being integral with the mobile part of the mini-piston comprising the aperture (33) designed to enable said communication, the cavity is delineated by at least one substrat (15, 17, 18) and the deformable parte of the micnipiston and the ends (28a, 28b) between which communication is to be established open out onto a face of a first planar surface in which the microchannels (16) of the microfluidic component are formed, the minipiston is formed in a second planar substrate (17) designed to be adjoined to the first planar substrate (15) and comprises a mobile part in the plane of the second substrate, the aperture (33) being formed in the mobile part of the minipiston (29), the deformable part of the micro-piston comprising linking zones (31) between the substrate and the mobile part of the mini-piston

2. The microvalve according to claim 1, **characterized in that** the microvalve being normally open, the aperture (33) of the mini-piston normally establishes communication between the ends (28a, 28b), the minipiston (29) preventing said communication after the pyrotechnic charge (20) has been fired.

3. The microvalve according to one of the claims 1 and 2, wherein the microvalve being normally closed, the minipiston (29) normally prevents communication between the ends (28a, 28b), the aperture (33) of the mini-piston establishing communication between the ends after the pyrotechnic charge (20) has been fired.

4. The microvalve according to anyone of the claims 1 to 3, **characterized in that** the mobile part of the mini-piston (29) is mobile in translation in the plane of the second substrate (17), the deformable part of the mini-piston comprising a transverse joining bar (36) integral with the mini-piston.

5. The microvalve according to anyone of the claims 1 to 3, **characterized in that** the mobile part of the mini-piston (29) is mobile in rotation in the plane of the second substrate (17).

6. The microvalve according to anyone of the claims 1 to 3, **characterized in that** the mini-piston (29) comprises a deformable part (29b) integral with the mobile part (29a), deformation of the deformable part perpendicularly to the plane of the second substrate (17) in response to firing of the pyrotechnic charge (20) causing movement of the mobile part (29a).

7. The microvalve according to anyone of the claims 1 to 6, **characterized in that** the aperture (33) is a pass-through aperture.

8. The microvalve according to anyone of the claims 1 to 6, **characterized in that** the aperture (33) is a blind aperture.

9. The microvalve according to anyone of the claims 1 to 8, **characterized in that** the aperture (33) is substantially U-shaped.

## Patentansprüche

1. Ventil, das dazu bestimmt ist, das Verbinden von Enden von Kanälen eines Fluidsystems durch das Bewegen eines mit einem Langloch (33) versehenen Kolbens unter der Schubwirkung von Gasen, die durch das Zünden einer in einem Hohlraum angeordneten pyrotechnischen Ladung (20) freigesetzt werden, zu ermöglichen oder zu verhindern, wobei das Ventil ein Mikroventil ist, wobei der Kolben ein Minikolben ist, der einen unter der Wirkung der Gase verformbaren Teil umfasst, wobei der verformbare Teil mit einem beweglichen Teil des Minikolbens, der das Langloch (33) aufweist, welches dazu bestimmt ist, die Verbindung herzustellen, fest verbunden ist, wobei der Hohlraum durch wenigstens ein Substrat (15, 17, 18) und den verformbaren Teil des Minikolbens begrenzt ist und wobei die miteinander zu verbindenden Enden (28a, 28b) an einer Seite eines ersten planaren Substrats (15) ausmünden, in dem die Mikrokanäle (16) der mikrofluidischen Komponente ausgebildet sind, der Minikolben (29) ist in einem zweiten planaren Substrat (17) ausgebildet, das dazu bestimmt ist, mit dem ersten planaren Substrat (15) verbunden zu werden, und umfasst einen beweglichen Teil in der Ebene des zweiten Substrats, wobei das Langloch (33) in dem beweglichen Teil des Minikolbens (29) ausgebildet ist, wobei der verformbare Teil des Minikolbens Verbindungsbereiche (31) zwischen dem Substrat und dem beweglichen Teil des Minikolbens aufweist.

2. Ventil nach Anspruch 1, **dadurch gekennzeichnet, dass** - wenn das Mikroventil normalerweise geöffnet ist - das Langloch (33) des Minikolbens normalerweise die Enden (28a, 28b) miteinander verbindet, wobei der Minikolben (29) nach dem Zünden der pyrotechnischen Ladung (20) die Verbindung verhindert.

3. Ventil nach einem der Ansprüche 1 und 2, **dadurch gekennzeichnet, dass** - wenn das Mikroventil normalerweise geschlossen ist - der Minikolben (29) normalerweise die Verbindung zwischen den Enden (28a, 28b) verhindert, wobei das Langloch (33) des Minikolbens sie nach dem Zünden der pyrotechnischen Ladung (20) miteinander verbindet.

4. Ventil nach einem der Ansprüche 1 bis 3, **dadurch gekennzeichnet, dass** der bewegliche Teil des Minikolbens (29) in der Ebene des zweiten Substrats (17) verscbiebebeweglich ist, wobei der verformbare Teil des Minikolbens eine mit dem Minikolben fest verbundene querverlaufende Verbindungsstange (36) umfasst.

5. Ventil nach einem der Ansprüche 1 bis 3, **dadurch gekennzeichnet, dass** der bewegliche Teil des Minikolbens (29) in der Ebene des zweiten Substrats (17) drehbeweglich ist.

6. Ventil nach einem der Ansprüche 1 bis 3, **dadurch gekennzeichnet, dass** der Minikolben (29) einen verformbaren Teil (29b) aufweist, der mit dem beweglichen Teil (29a) fest verbunden ist, wobei die Verformung des verformbaren Teils senkrecht zur Ebene des zweiten Substrats (17), als Reaktion auf das Zünden der pyrotechnischen Ladung (20) die Bewegung des beweglichen Teils (29a) bewirkt.

7. Ventil nach einem der Ansprüche 1 bis 6, **dadurch gekennzeichnet, dass** das Langloch (33) ein durchgehendes Langloch ist.

8. Ventil nach einem der Ansprüche 1 bis 6, **dadurch gekennzeichnet, dass** das Langloch (33) ein Sacklangloch ist.

9. Ventil nach einem der Ansprüche 1 bis 8, **dadurch gekennzeichnet, dass** das Langloch (33) im Wesentlichen die Form eines U aufweist.
